# EUROPEAN PATENT SPECIFICATION

(11) **EP 0 358 390 B1**
(45) Date of publication and mention of the grant of the patent: **20.10.1993**
(21) Application number: 89308665.2
(22) Date of filing: 25.08.1989
(51) Int. Cl.: G01V 1/20, H01L 41/08

(54) **Piezoelectric transducer**
Piezoelektrischer Wandler
Transducteur piézoélectrique

(30) Priority: 07.09.1988 JP 224087/88
(43) Date of publication of application: 14.03.1990
(73) Proprietor: NGK SPARK PLUG CO., LTD, Nagoya-shi Aichi-ken (JP)
(72) Inventor: Ogura, Kohji, Nagoya-shi Aichi-ken (JP)
(74) Representative: Cheyne, John Robert Alexander Mackenzie

(56) References cited:
- FR-A- 2 373 784
- FR-A- 2 468 694
- US-A- 4 047 166

## Description

This invention relates to a piezoelectric transducer generating an electric signal when subjected to a mechanical stress and, more specifically, to an elongated, piezoelectric transducer having an elongated, piezoelectric element in the form of a coaxial cable. The present invention is also concerned with a method of fabricating such a transducer.

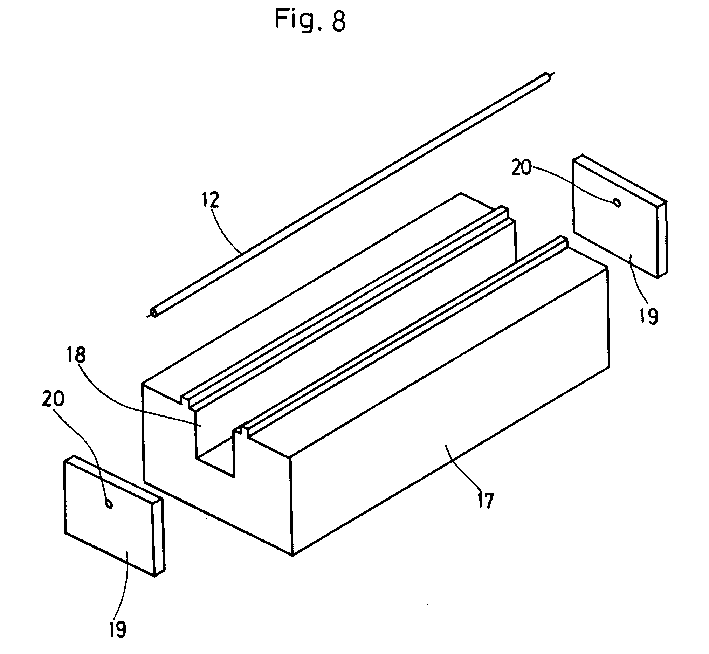

It is known to provide an elongated, piezoelectric transducer transversely on a road for detecting the passage of a car over the transducer. One known transducer is shown in Fig. 7. Designated generally as 11 is the transducer having a straight, coaxial cable-type piezoelectric element 12 surrounded by an urethane resin layer 16. The element 12 is composed of a core electrode 13, an outer electrode layer 15 and a piezoelectric layer 14 provided between the core and outer electrodes 13 and 15. As the piezoelectric layer 14, ferroelectric ceramic particles (e.g. lead titanate/lead zirconate or lead titanate) dispersed in a matrix of a synthetic rubber or an elastomer are generally used. A transducer of this type is disclosed by FR-A-2 373 784.

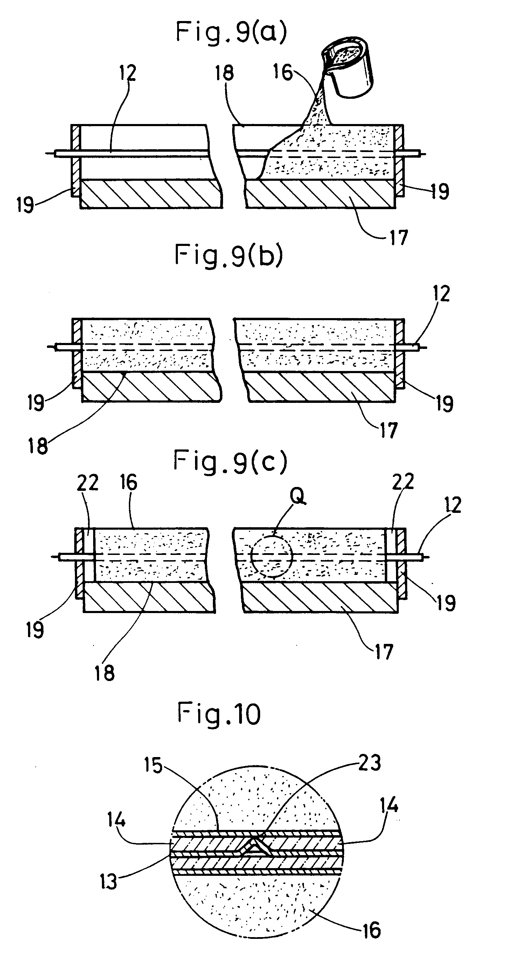

The above transducer 11 is generally prepared by a casting method using a mold 17 shown in Fig. 8. The piezoelectric element 12 is disposed in a mold cavity 18 of the mold 17 with the both ends thereof inserted through openings 20 of opposite side closure plates 19. After the closure of the plates 19 as shown in Fig. 9(a), a liquid resin 16 is poured into the mold cavity 18 and is cured at an elevated temperature, e.g. at 60 °C (Fig. 9(b)). Then, the cured resin is allowed to be cooled to room temperature to form the insulating layer 16 around the piezoelectric element 12 (Fig. 9(c)). In this case, due to the shrinkage of the resin during the cooling step, there is formed a gap 22 between each end of the insulating resin layer 16 and its adjacent closure plate 19.

It has been found that the above known piezoelectric transducer 11 is apt to cause operation failure due to short-circuit between the core electrode 13 and the outer electrode 15 of the piezoelectric element 12. The investigation by the present inventors has revealed that the short-circuit is caused by bend of the core electrode 13 due to the shrinkage of the resin layer 16 during the fabrication of the piezoelectric transducer 11.

More particularly, the coefficients of linear expansion of a stainless steel which is generally used for the formation of the core electrode 13 and a polyurethane which is generally used for the formation of the insulating resin layer 16 are 10⁻⁵ and 10⁻⁴ cm/cm/°C, respectively. Thus, when the temperature is changed from 60 °C (curing temperature) to 20 °C (room temperature), the polyurethane layer 16 shrinks by 0.4 % while the core electrode 13 shrinks by 0.04 %. Because of this difference in degree of the shrinkage and because of the lengthiness of the transducer, the core electrode 13 is bent to form a curved portion 23 as shown in Fig. 10. The bent portion 23 sometimes extends out of the piezoelectric layer 14 and contacts the outer electrode 15 to cause short-circuit.

In accordance with one aspect of the present invention there is provided a piezoelectric transducer comprising an elongated, piezoelectric element including a core electrode, a piezoelectric layer surrounding said core electrode, and an outer electrode layer surrounding said piezoelectric layer, and an elongated, electrically insulating molded synthetic resin layer surrounding said piezoelectric element, characterized in that element has a non-straight shape.

In another aspect, the present invention provides a method of fabricating a piezoelectric transducer having an elongated, piezoelectric element surrounded by an electrically insulating layer formed of a synthetic resin, wherein the element is placed in a mold cavity and a liquid resin is poured thereinto, cured for solidification and then cooled, thereby to form the insulating layer surrounding the element, characterized in that the element is disposed in said mold cavity after the element has been formed into a non-straight shape.

The present invention will now be described in detail below with reference to the accompanying drawings in which:
Fig. 1 is a perspective view diagrammatically showing one embodiment of piezoelectric transducer according to the present invention;
Fig. 2 is a schematic illustration of a mold to be used for the fabrication of the transducer;
Figs. 3(a) through 3(c) are schematic illustrations of the steps of a method of fabricating a piezoelectric transducer;
Fig. 3(d) is a view similar to Fig. 3(b) showing an alternative fabrication method;
Fig. 4 is a perspective view showing a piezoelectric element of a further embodiment of piezoelectric transducer of the present invention;
Fig. 5 is a perspective view of the piezoelectric transducer using the element of Fig. 4;
Fig. 6 is a perspective view similar to Fig. 4 showing an alternative embodiment of piezoelectric element;
Fig. 7 is a perspective view similar to Fig. 1 showing a conventional piezoelectric transducer;
Fig. 8 is an arrangement of a mold to be used for the fabrication of the conventional piezoelectric transducer;
Figs. 9(a) through 9(c) are schematic illustration of the steps for the fabrication of the conventional piezoelectric transducer;
Fig. 10 is a schematic, enlarged view of a portion Q in Fig. 9(c); and
Fig. 11(a) and 11(b) are cross-sectional views each showing the state of the transducer as fabricated in a mold.

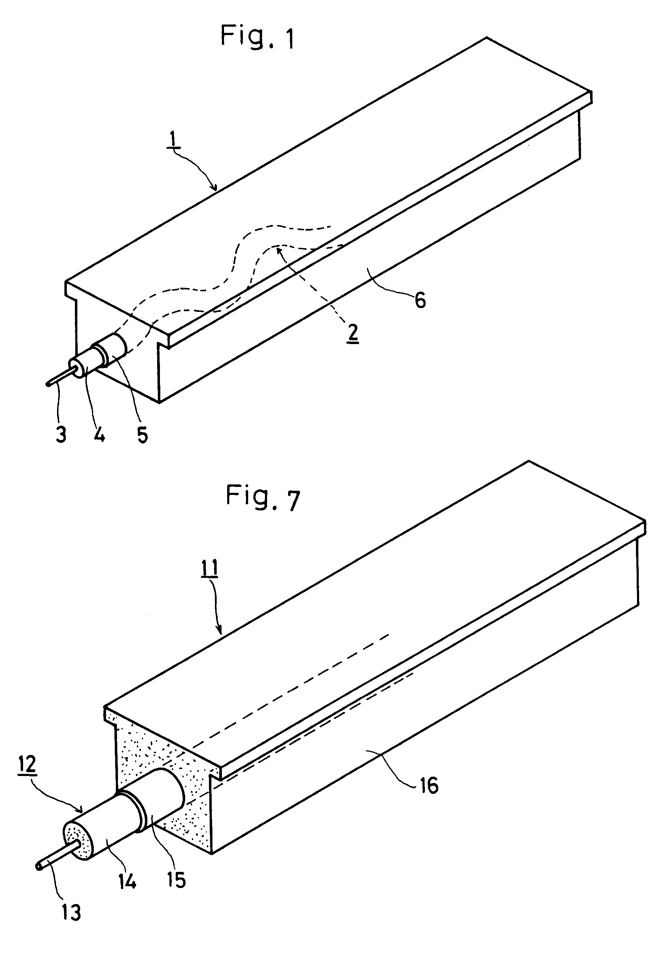

Referring now to Fig. 1, designated generally as 1 is a piezoelectric transducer of the present invention which is composed of an elongated, piezoelectric element 2 and an elongated, electrically insulating layer 6 surrounding the piezoelectric element 2. The element 2 is constructed in the form of a coaxial cable and includes a core electrode 3, a piezoelectric layer 4 surrounding the core electrode 3 and an outer electrode layer 5 surrounding the piezoelectric layer 4. It is important that the piezoelectric element 2 has a non-straight shape. In the embodiment shown in Fig. 1, the piezoelectric element is in a meandering shape. Other shapes such as spiral shape and twisted shape may be also suitably used.

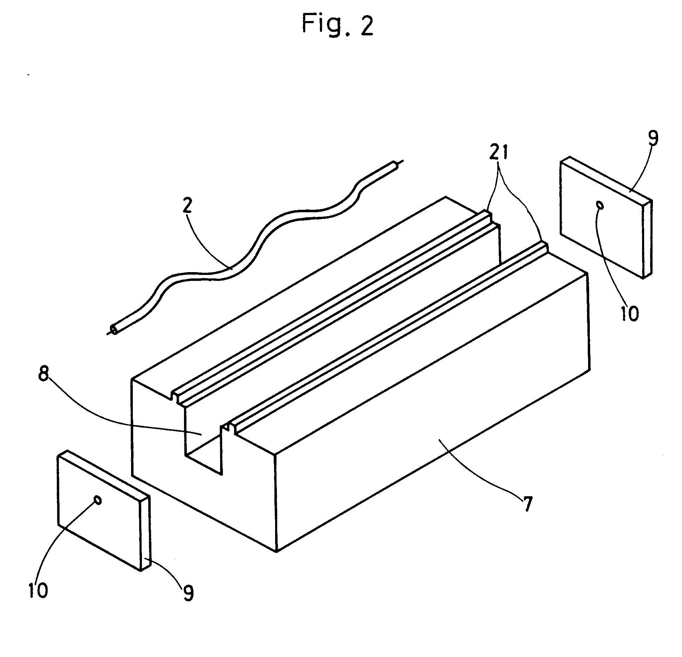

Fig. 2 depicts a mold 7 for the fabrication of the transducer 1. The mold 7 has a mold cavity 8 and opposite side plates 9 having openings 10. The reference numeral 21 denotes opposing ribs for forming flanged top portion of the transducer 1. The element 2 is disposed within the mold cavity with both end portions thereof being inserted through the openings 10 of the plates 9 assembled to the mold 7 in position. Thereafter, a liquid resin composition or a melt of a resin is poured into the mold cavity and cured. After cooling, the cast product is taken out of the mold 7 to obtain the transducer 1 of the present invention.

Since the piezoelectric element 2 is previously formed into a non-straight shape, it can be deformed during the cooling step as a whole rather than at a specific location so that there is no fear of the occurrence of short-circuit as seen in the conventional piezoelectric transducer having a straight piezoelectric element.

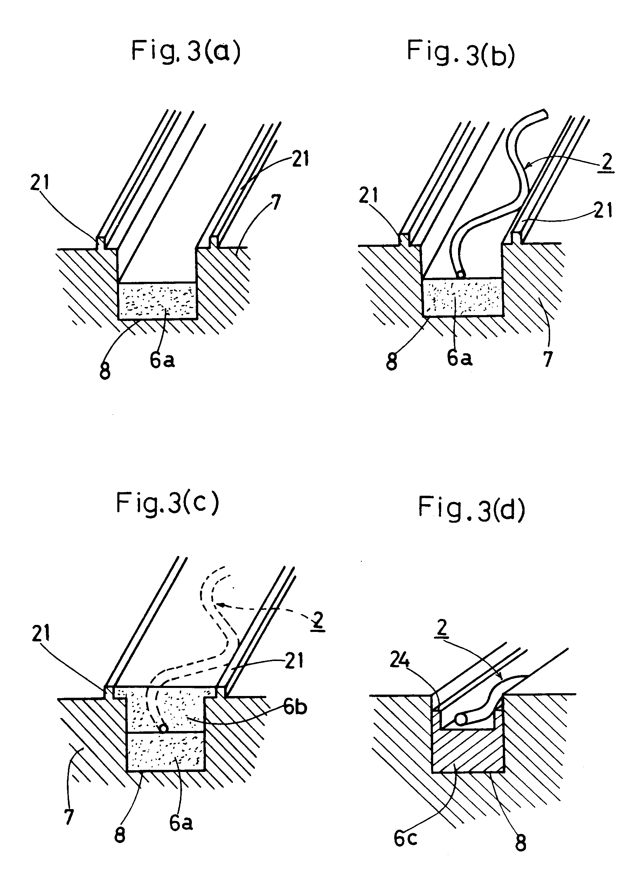

Figs. 3(a) through 3(c) illustrate an alternate method for the fabrication of the piezoelectric transducer using the mold 7 of Fig. 2. A suitable amount of a liquid resin is first poured into the mold cavity and cured so that the top surface of the cured resin 6a is positioned at the same level of the lower portion of the openings 10 of the plates 9 (Fig. 3(a)). The element 2 is then placed on the top surface of the cured resin 6a (Fig. 3(b)) which is a lower part of the insulating layer 6. Subsequently, the remainder of the liquid resin is poured into the mold cavity and cured to form an upper part 6b (Fig. 3(c)) of the insulating layer 6.

In this case, it is possible to form upwardly extending portions 24 on the top of a lower part 6c as shown in Fig. 3(d) for the purpose of preventing the meandering element 2 from displacing laterally during molding and from exposing on the side surface of the insulating layer 6 . Such raised portions 24 can be formed by mounting a flanged top cover at the time of performing the curing of the resin.

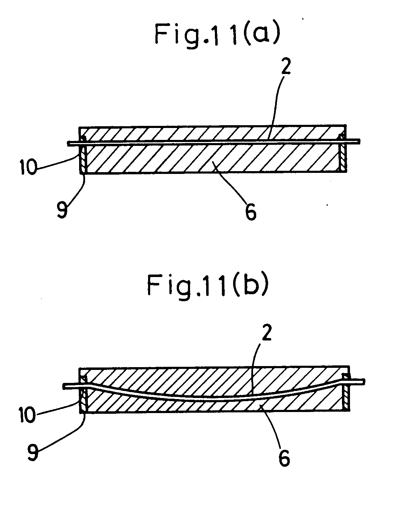

The above two stage molding method has an advantage because flexure of the elongated, piezoelectric element 2 can be avoided. More particularly, since the piezoelectric element 2 has a length of generally about 7 meters, the element 2 tends to flex as shown in Fig. 11 (b) by its own weight when it is supported only at both end portions by the plates 9. As a result, the depth of the element 2 from the top surface of the insulating layer 6 varies with the position thereof. It follows that the transducers have various different sensitivity from each other. On the other hand, by employing the above two stage molding method, since the element 2 is in supported engagement with the top surface of the lower part 6a of the insulating layer 6, no flexure of the element 2 is caused during the fabrication of the transducer as shown in Fig. 11(a). Thus, the transducers obtained by the above method have uniform sensitivity.

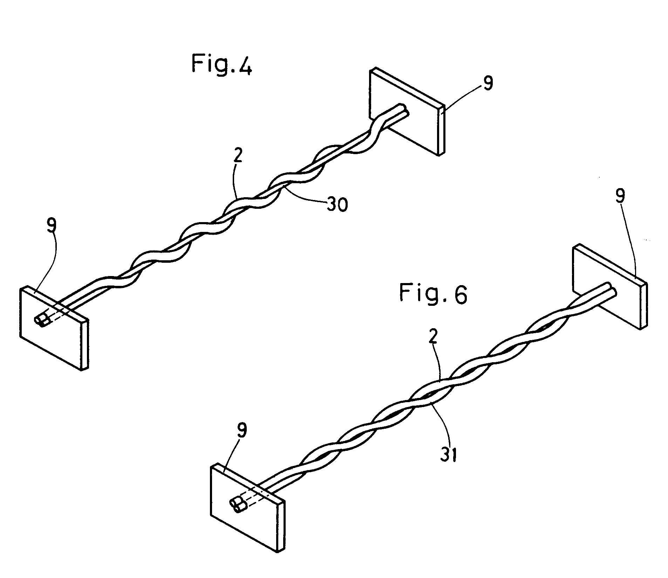

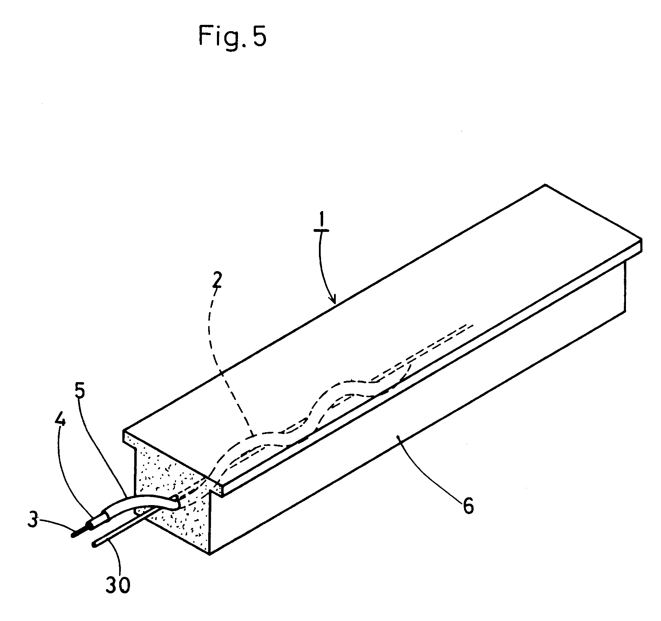

The prevention of flexure of the element 2 may also be attained by using an elongated support member. Fig. 4 is one such embodiment in which the piezoelectric element 2 is wound around a rigid straight member 30 such as a piano wire. Both ends of the wound are supported by insertion through the openings 10 of the plates 9 during molding. The resulting transducer has a structure shown in Fig. 5.

In an alternate embodiment shown in Fig. 6, the element 2 is bound to an elongated member 31 by twist. The elongated member 31 may be a metal wire or another piezoelectric element of the same structure as the element 2.

Since the piezoelectric transducer according to the present invention uses a non-straight shaped piezoelectric element, shrinkage of the insulating layer during the fabrication of the transducer can be evenly absorbed by the element so that there is no fear of the occurrence of shortcircuit caused by local bend of the core electrode. In addition, the transducer according to the present invention has an improved resistance to a tensile force and exhibits a longer service life in comparison with the conventional transducer having a straight piezoelectric element.

## Claims

1. A piezoelectric transducer comprising an elongated, piezoelectric element (2) including a core electrode (3), a piezoelectric layer (4) surrounding said core electrode (3), and an outer electrode layer (5) surrounding said piezoelectric layer (4), and an elongated, electrically insulating molded synthetic resin layer (6) surrounding said piezoelectric element (2), characterized in that said piezoelectric element (2) has a non-straight shape.

2. A piezoelectric transducer according to claim 1, characterized in that said piezoelectric element (2) is in a meandering shape.

3. A piezoelectric transducer according to claim 1, characterized in that said piezoelectric element (2) is in a spiral shape.

4. A piezoelectric transducer according to claim 3, characterized in that said transducer further comprises a rigid straight member (30) which is disposed within said insulating layer (6) and around which said piezoelectric element (2) is wound.

5. A piezoelectric transducer according to claim 1, characterized in that said transducer further comprises an elongated member (31) with which said piezoelectric element (2) is bound by twist.

6. A piezoelectric transducer according to claim 5, characterized in that said elongated member (31) is a metal wire.

7. A piezoelectric transducer according to claim 5, characterized in that said elongated member (31) is another piezoelectric element of the same structure as said element (2).

8. A method of fabricating a piezoelectric transducer having an elongated, piezoelectric element (2) surrounded by an electrically insulating layer (6) formed of a synthetic resin, wherein the element (2) is placed in a mold cavity (8) and a liquid resin is poured thereinto and then cured for solidification, thereby to form the insulating layer (6) surrounding the element (2), characterized in that the element (2) is disposed in said mold cavity (8) after the element (2) has been formed into a non-straight shape.

9. A method according to claim 8, characterized in that a portion of said liquid resin is poured into and cured in said mold cavity and that the remainder of the liquid resin is poured into said mold cavity after the element (2) has been placed on said cured resin in said mold cavity.

## Patentansprüche

1. Piezoelektrischer Wandler mit einem piezoelektrischen Langelement (2), beinhaltend eine Kernelektrode (3), eine piezoelektrische Schicht (4), die die Kernelektrode (3) umgibt, eine äußere Elektrodenschicht (5), die die piezoelektrische Schicht (4) umgibt, sowie eine längliche, elektrisch isolierende, gegossene Kunstharzschicht (6), die das piezoelektrische Element (2) umgibt, dadurch gekennzeichnet, daß das piezoelektrische Element (2) von nicht-linearer Gestalt ist.

2. Piezoelektrischer Wandler nach Anspruch 1, dadurch gekennzeichnet, daß das piezoelektrische Element (2) mäanderförmig ist.

3. Piezoelektrischer Wandler nach Anspruch 1, dadurch gekennzeichnet, daß das piezoelektrische Element (2) spiralförmig ist.

4. Piezoelektrischer Wandler nach Anspruch 3, dadurch gekennzeichnet, daß der Wandler ferner ein starres, in der Isolierschicht (6) angeordnetes, gerades Teil (3) aufweist, um das das piezoelektrische Element (2) gewunden ist.

5. Piezoelektrischer Wandler nach Anspruch 1, dadurch gekennzeichnet, daß der Wandler ferner ein längliches Teil (31) aufweist, mit dem das piezoelektrische Element (2) durch Verdrillen verbunden ist.

6. Piezoelektrischer Wandler nach Anspruch 5, dadurch gekennzeichnet, daß das längliche Teil (31) ein Metalldraht ist.

7. Piezoelektrischer Wandler nach Anspruch 5, dadurch gekennzeichnet, daß das längliche Teil (31) ein weiteres piezoelektrisches Element von gleicher Beschaffenheit wie das Element (2) ist.

8. Verfahren zur Herstellung eines piezoelektrischen Wandlers mit einem piezoelektrischen Langelement (2), umgeben von einer elektrischen Isolierschicht (6) aus Kunstharz, wobei das Element (2) in einer Gußformvertiefung (8) angeordnet wird; dann wird ein flüssiges Harz dort hineingegossen und bis zur Verfestigung gehärtet, so daß eine Isolierschicht (6), die das Element (2) umgibt, erhalten wird, dadurch gekennzeichnet, daß das Element (2) in der Gußformvertiefung (8), nachdem das Element (2) hergestellt wurde, in nicht-gerader Gestalt angeordnet wird.

9. Verfahren nach Anspruch 8, dadurch gekennzeichnet, daß ein Teil des flüssigen Harzes in die Gußvorvertiefung gegossen und gehärtet wird, daß das Element (2) auf das gehärtete Harz in der Gußformvertiefung gelegt wird und daß dann der Rest des flüssigen Harzes in die Gußformvertiefung gegossen wird.

## Revendications

1. Transducteur piézoélectrique comprenant un élément piézoélectrique allongé (2) comprenant une électrode centrale (3), une couche piézoélectrique (4) entourant l'électrode centrale (3), et une couche extérieure (5) formant électrode et entourant la couche piézoélectrique (4), et une couche allongée (6) en résine synthétique moulée isolante de l'électricité et entourant l'élément piézoélecthque (2), caractérisé en ce que l'élément piézoélectrique (2) a une forme non rectiligne.

2. Transducteur piézoélectrique selon la revendication 1, caractérisé en ce que l'élément piézoélectrique (2) a une forme sinueuse.

3. Transducteur piézoélectrique selon la revendication 1, caractérisé en ce que l'élémernt piézoélectrique (2) a une forme hélicoïdale.

4. Transducteur piézoélectrique selon la revendication 3, caractérisé en ce qu'il comprend, en outre, une pièce rectiligne rigide (30) qui est disposée à l'intérieur de la couche isolante (6) et autour de laquelle est enroulé l'élément piézoélectrique (2).

5. Transducteur piézoélectrique selon la revendication 1, caractérisé en ce qu'il comprend, en outre, une pièce allongée (31) avec laquelle l'élément piézoélectrique (2) est assemblé par torsion.

6. Transducteur piézoélectrique selon la revendication 5, caractérisé en ce que la pièce allongée (31) est un fil métallique.

7. Transducteur piézoélectrique selon la revendication 5, caractérisé en ce que la pièce allongée (31) est un autre élément piézoélectrique ayant la même structure que ledit élément (2).

8. Procédé de fabrication d'un transducteur piézoélectrique comportant un élément piézoélectrique allongé (2) entouré par une couche électro-isolante (6) formée d'une résine synthétique, procédé dans lequel l'élément (2) est placé dans une cavité (8) de moule et une résine liquide est versée dans cette cavité puis vulcanisée en vue d'une solidification, de manière à former ainsi la couche isolante (6) entourant l'élément (2), caractérisé en ce que l'élément (2) est disposé dans la cavité (8) de moule après que l'on ait donné à l'élément (2) une forme non rectiligne.

9. Procédé selon la revendication 8, caractérisé en ce qu'une partie de la résine liquide est versée dans la cavité de moule et vulcanisée dans cette dernière, et que le restant de la résine liquide est versé dans la cavité de moule après que l'élément (2) ait été placé sur ladite résine vulcanisée dans la cavité de moule.
